# EUROPEAN PATENT SPECIFICATION

(11) **EP 1 276 270 B1**
(45) Date of publication and mention of the grant of the patent: **12.10.2005**
(21) Application number: 02360203.0
(22) Date of filing: 08.07.2002
(51) Int. Cl.: H04J 3/04, H04L 7/033, H03L 7/08

(54) **Method and arrangement for recovering a clock signal from a data signal**
Verfahren und Vorrichtung zur Taktrückgewinnung aus einem Datensignal
Procédé et dispositif de récupération d'horloge d'un signal de données

(30) Priority: 09.07.2001 DE 10132403
(43) Date of publication of application: 15.01.2003
(73) Proprietor: ALCATEL, 75008 Paris (FR)
(72) Inventor: Wedding, Berthold, Dr., 70825 Korntal-Münchingen (DE)
(74) Representative: Rausch, Gabriele

(56) References cited:
- EP-A- 0 614 283
- EP-A- 1 239 627
- ISHIHARA N ET AL: "3.5-GB/S X 4-CH SI BIPOLAR LSI'S FOR OPTICAL INTERCONNECTIONS" , IEEE JOURNAL OF SOLID-STATE CIRCUITS, IEEE INC. NEW YORK, US, VOL. 30, NR. 12, PAGE(S) 1493-1500 XP000557255 ISSN: 0018-9200 * abstract * * Section IV. A. 2) Data and Clock Recovery PLL * * Section IV. C. 2) 1-to-5 DEMUX * * Fig. 6, 12 *
- "ASYNCHRONOUS DATA SAMPLING TECHNIQUE UTILIZING DUAL GATED OSCILLATORS WITH PASSIVE DELAY LINES" , IBM TECHNICAL DISCLOSURE BULLETIN, IBM CORP. NEW YORK, US, VOL. 36, NR. 2, PAGE(S) 251-254 XP000354327 ISSN: 0018-8689 * page 251 - page 252 * * figure 1 *

## Description

### Background of the invention:

This invention relates to a method of and an arrangement for recovering a clock signal from a data signal. It is particularly suited for recovering a clock signal from high-bit-rate data signals.

Clock recovery circuits are basically known, but in general they are not suited for high-bit-rate data signals, such as signals with data rates up to 40-Gb/s.

For clock recovery from a 40-Gb/s data signal, a filterlike circuit with nonlinear signal preprocessing is known. The input signal is fed to a decision circuit, with the clock signal for the decision circuit being recovered from the data signal itself. This is done by nonlinear prefiltering which involves differentiating the data signal to generate a discrete clock frequency in the frequency spectrum of the data signal and subsequently generating the absolute value of the data signal or squaring it. The signal obtained is then processed with a bandpass filter to filter out the discrete clock frequency, passed through a phase shifter, and applied as a clock signal to the decision circuit.

Such a circuit is susceptible to thermal drift, if only because of the great number of components which process the 40-Gb/s signal. This applies in particular to the narrow bandpass filter. Moreover, bandpass filters for such high frequencies cannot be produced in the form of an electric circuit as a combination of a high-pass and a low-pass filter but must be realized in the form of cavity resonators or suitable crystals, for example. Because of the physical limiting conditions, such filters have a minimum size which precludes an implementation of the overall circuit as an integrated circuit. Therefore, the bandpass filter is commonly connected to the outside world by cable, whereby tuning and the avoidance of thermal drift are additionally complicated.

A circuit for signal recovery and an integrated PLL is known form "3.5 Gb/s × 4 Ch SI bipolar LSI's for Optical Interconnections", N. Ishihara, IEEE Journal of

Solid State Circuits, 30(1995), December , No. 12. The document discloses a PLL with a fixed delay and a phase measurement between the delayed and the decided signal. The circuit struggles from the problem to be dependent from data mork ratio is certain circumstances.

### Summary of the invention:

The invention has for its object to provide a method and an arrangement with which the disadvantages of the above-mentioned prior art are overcome.

To attain the object, a method as set forth in claim 1 and an arrangement as set forth in claim 3 are proposed.

According to the invention, a data signal or input signal is synchronized in a decision circuit with a clock signal, the control of this clock signal being effected by evaluating the phase difference between synchronized data signal and nonsynchronized data signal, i.e., the data signal not processed in the decision circuit. The synchronized data signal, i.e., the signal at the output of the decision circuit, is fed back to an input of the phase detector, in which the phase difference between the nonsynchronized data or input signal and the synchronized data or input signal is determined bit-synchronously. "Bit-synchronous" as used herein means that the phase detector each time compares the same bits or the same bit sequences of the data signal which is applied to the phase detector in the form of the nonsynchronized and the synchronized data signal. To this end, a delay circuit is provided which ensures essentially equal signal propagation times to the inputs of the phase detector. Advantageously, the nonsynchronized signal, i.e., the data signal not processed in the decision circuit, is delayed, so that the propagation times of the data signal through the decision circuit to a first input of the phase detector and of the data signal through the delay circuit to a second input of the phase detector are essentially the same, i.e., that the delay differences are less than the duration of one bit.

The invention is based on a comparison between decided signal and nondecided signal. Such a method or a circuit is also referred to as "decision-directed", so that one can speak of a decision-feedback phase-locked loop (DFPLL). Advantageously, for the clock recovery, the data signal as such is processed essentially in the phase detector. High-bit-rate signals can be readily delayed by means of delay circuits. Accordingly, an advantage of the invention over the prior art is that it uses a small number of modules or components which must be suitable for high-bit-rate signals. In addition, the decision circuit and the phase detector, through both of which the data signal is passed, can be implemented with similar circuitry, so that the effects of temperature in the two subcircuits can be at least partly compensated for, thus reducing the problem of thermal drift. That will be the case particularly if essentially the same components, e.g., D flip-flops, are used for the decision circuit and the phase detector. Furthermore, the invention does not require a filter for high-frequency signals, such as the bandpass filter of the prior-art filter circuit. The loop filter following the phase detector is operated at much lower frequencies, e.g., 10 MHz, and is well suited for integration.

In a preferred embodiment of the invention, the portion of the input signal fed to the decision circuit is demultiplexed. This has the advantage that the signal appearing at the output of the decision circuit has a lower frequency, so that the frequency requirements placed on the phase detector or its components are reduced and that data signals of higher frequency can be processed. This is particularly advantageous if the phase detector is implemented in the form of a D flip-flop, because then the clock input of the D flip-flop, which limits the operating frequency of the latter, is connected to an output of the decision circuit, i.e., this clock input has the demultiplexed, synchronized clock signal applied to it. The demultiplexing is preferably accomplished by means of a demultiplexer decision circuit. The demultiplexer decision circuit is implemented, for example, by connecting several decision circuits in parallel, with the decisions circuits being operated with a clock signal which is reduced in frequency and correspondingly shifted in phase, so that each decision circuit samples different parts of the input signal. The implementation of the decision circuit with D flip-flops is particularly advantageous in that such a solution takes into account the frequency-limiting properties of the clock input and permits the processing of higher-frequency signals with respect to the demultiplexer decision circuit.

In another preferred embodiment of the invention, the lock-in frequency of the voltage-controlled oscillator is determined by means of a frequency-locked loop. Locking of the PLL to the control frequency requires that the initial frequency deviation should lie within the capture range of the PLL. This capture range is determined mainly by the phase detector used and the voltage-controlled oscillator. Via the additional frequency-locked loop, locking of the PLL is ensured even under unfavorable initial conditions. In addition, different lock-in frequencies or control frequencies can be predetermined, i.e., the method and the arrangement according to the invention can be used at different frequencies, i.e., for signals with different bit rates, or adapted to such signals. Different error-correcting techniques require different bit-rate increases. A forward error correction (FEC) according to ITU Recommendation G.709 requires a bit-rate increase of approx. 7%, for example. The frequency-locked loop thus allows an adaptation of the invention to different error-correcting techniques or their implementation.

In a preferred embodiment of the arrangement, the frequency-locked loop comprises a frequency divider, a frequency counter, and a microprocessor. Such a frequency-locked loop permits highly flexible handling, since the desired frequency or frequency change can be entered in a simple manner by software.

Further advantages and developments of the invention are apparent from the description and the accompanying drawings.

It is to be understood that the aforementioned features and the features explained below can be used not only in the respective combinations described but also in other combinations or alone without departing from the scope of the present invention.

### Brief description of the drawings:

The invention will become more apparent from the following description of an embodiment taken in conjunction with the accompanying drawings, in which:
- Fig. 1: shows a filterlike circuit of the prior art for clock recovery from a data signal;
- Fig. 2: is a schematic block diagram of a first embodiment of the invention;
- Fig. 3: is a timing diagram for the first embodiment of the invention, shown in Fig. 2;
- Fig. 4: shows a second embodiment of the invention; and Fig. 5 is a timing diagram for the second embodiment of the invention, shown in Fig. 4.

### Description of preferred embodiments:

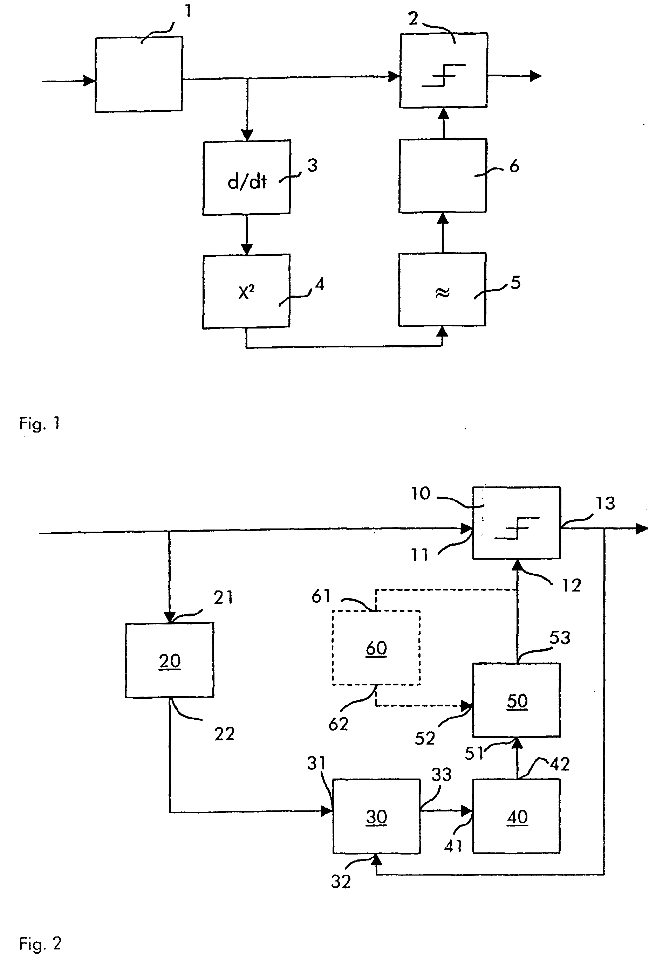

Fig. 1 shows a filterlike circuit of the prior art for clock recovery from a data signal. The data signal is first amplified in an amplifier 1 and then fed to a decision circuit 2 for synchronization with a clock signal. The clock signal for the synchronization is derived from the data signal itself. To this end, a portion of the amplified signal is subjected to nonlinear filtering: The signal is processed with a differentiator 3, and the positive and negative signals obtained are fed to a squarer 4 to generate their absolute values. The discrete frequency components of the clock signal is filtered out of the signal frequency spectrum by means of a bandpass filter 5, and the clock signal thus determined is applied through a phase shifter 6 to the clock input of the decision circuit. A principal disadvantage of this circuit is that bandpass filters for high-frequency signals are not suitable for integration, if only because of their size.

Fig. 2 shows a schematic block diagram of a first embodiment of a clock recovery circuit in accordance with the invention. The circuit comprises a decision circuit 10, a delay circuit 20, a phase detector 30, a loop filter 40, and a controlled oscillator 50, which is designed as a voltage-controlled oscillator, for example. Furthermore, a frequency-locked loop 60 is preferably provided, which is represented in Fig. 2 by dashed lines.

Decision circuit 10 has two inputs 11, 12 and one output 13. Various decision circuits familiar to those skilled in the art can be used. Preferably, decision circuit 10 is implemented with one or more D flip-flops (not shown in Fig. 1). Then, the data input of the D flip-flop is connected to or represents the first input 11 of decision circuit 10, the clock input of the D flip-flop is connected to or represents the second input 12 of the decision circuit, and the output of the D flip-flop is connected to or represents the output 13 of the decision circuit. With such an implementation of the decision circuit, both the amplitude decision and the timing decision are made by means of the D flip-flop. The amplitude decision can also be made by means of a comparator connected ahead of the flip-flop. In that case, the timing decision continues to be made by means of the flip-flop, and the input of the flip-flop is connected to the input 11 of decision circuit 10 via the comparator. The output 13 of decision circuit 10 is fed back to phase detector 13.

Phase detector 30 has two inputs 31, 32 and an output 33, with the first input 32 connected to output 13 of decision circuit 10. For the phase detector 30, various circuits familiar to those skilled in the art can be used. These include phase detectors in the form of a sample-and-hold circuit, a synchronous detector, or an up-down counter. Phase detector 30 is preferably implemented with a D flip-flop, the data input of the latter being connected to or representing the input 31 of the phase detector, the clock input being connected to or representing the input 32, and the output of the D flip-flop being connected to or representing the output 33. The second input 31 of phase detector 30 is connected to the output 22 of delay circuit 20. The delay circuit is implemented, for example, in the form of an all-pass network or an electric conductor of suitable length. Output 33 of phase detector 30 is connected via loop filter 40 to one input 51 of voltage-controlled oscillator 50. For the latter, conventional voltage-controlled oscillators or oscillator circuits can be used which are selected to meet the respective requirements of the circuit, such as frequency, control range, quality, etc. Phase detector 30, loop filter 40, and voltage-controlled oscillator 50 are elements of a phase-locked loop (PLL) whose quality is determined essentially by the loop filter 40, which is generally a low-pass filter.

In a preferred embodiment of the invention, a frequency-locked loop 60 is provided whose input 61 is connected to output 53 of voltage-controlled oscillator 50, and whose output 62 is coupled to a second input 52 of the oscillator. Via the frequency-locked loop 60, the lock-in frequency of the PLL or the control frequency of voltage-controlled oscillator 50 can be preset or changed.

A data signal from which a clock signal is to be recovered by means of the circuit in accordance with the invention is applied both to the input 1 of decision circuit 10 and to an input 21 of delay circuit 20. In the decision circuit 10, the data signal is synchronized with the clock signal, which is determined from the data signal itself. For an exact derivation or determination of the clock signal from the data signal, the synchronized signal is compared with the input signal in phase detector 30. Such a comparison requires that the two signals be applied to the phase detector bit-synchronously, i.e., that phase detector 30 each time compare the same bits or bit sequences.
To this end, phase detector 30 is preceded by the delay circuit 20, which delays the input signal for input 31 such that the data signal and the synchronized data signal appear at the inputs 31 and 32 bit-synchronously, i.e., simultaneously with respect to one bit as a unit of time. In other words, the time difference between the input signal and the synchronized signal at phase detector 30 must be less than one clock period of the signal. During the synchronization of the input signal in decision circuit 10, the signal is sampled essentially in the middle.

Phase detector 30 compares the two signals with respect to one of their signal edges, for instance the leading edge.

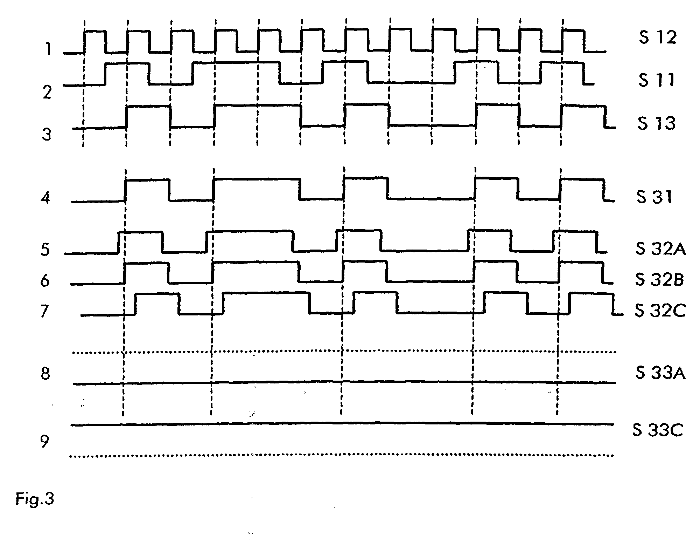

Fig. 3 is a timing diagram for the circuit of Fig. 2. It is assumed that decision circuit 10 and phase detector 30 are each implemented with an edge-triggered D flip-flop as described above, which is triggered on the rising edge, for example.

The first line of the diagram shows the clock signal S 12 of decision circuit 10 or the output 53 of voltage-controlled oscillator 50. The data rate and the frequency of the clock signal to be recovered have a ratio of 1:1. The data signal, which is designated S 11 and presented to input 11 of decision circuit 10, is shown in line 2. Line 3 shows the output signal S 13 of decision circuit 10, i.e., the data signal S 11 synchronized with the clock signal
S 12, which is also fed back to the clock input 32 of the D flip-flop of phase detector 30. The vertical dashed lines illustrate that the data signal S 11 is sampled by means of the clock signal S 12 preferably in the middle of the signal. With correct sampling, the input and output signals of the decision circuit are identical in content but shifted in time relative to each other.

Lines 1 to 3 represent the case where the loop is in the steady-state condition, i.e., the desired operating point for the clock recovery. From line 4, the processes taking place in the event of an initial phase error of oscillator 50 are represented. An optimally set delay of the unsampled data signal S 31 in delay circuit 20 is assumed. With an optimum delay, which must be set only once at the beginning, S 31 is exactly in phase with S 13, whereby the optimum operating point of the clock recovery is achieved.

Line 4 shows the nonsynchronized, optimally delayed data signal S 31, which is applied to the data input 31 of the D flip-flop of phase detector 30. Lines 5 to 7 show the synchronized data signal S 32 presented to the clock input 32 of phase detector 30, namely for the cases of a synchronized data signal S 32A (line 5), with the clock signal S 12 leading the data signal S 11, of a synchronized data signal S 32B (line 6), with the clock signal S 12 locked to with the data signal S 11, and of a synchronized data signal S 32C (line 7), with the clock signal S 12 lagging the data signal S 11.

In phase detector 30, the delayed signal S 31 is sampled at the instant of a rising edge of the signal applied at clock input 32, i.e., of the synchronized data signal S 13. Lines 8 and 9 show the output signals S 33A and S 33C of the phase detector or D flip-flop for the leading and lagging input signals S 32A and S 32C, respectively. When the clock signal leads the data signal, the rising edge of S 32 samples exclusively low levels of S 31 by means of phase detector 30, so that S 33A (line 8) is permanently low. When the clock signal lags the data signal, exclusively high levels of S 31 are sampled, so that S 33C (line 9) is permanently high.

The case of the phase-locked clock signal S 12 results in coincidence of S 31 and S 32 and is not shown. At first this is surprising, because this is the very signal state that is to be adjusted by the circuit. Actually, the state of S 33 in this case is not uniquely defined; because of the metastability of the D flip-flop in phase detector 30, high and low levels occur at random and in a uniform distribution. The signal S 33, on a time average, takes on the average value between high level and low level. Such time averaging of the signals from phase detector 30 is performed by loop filter 40.

S 33, as shown, is a criterion of the lead or lag of the clock signal recovered from the data. During operation of the circuit, a sequence of high and low bits will be applied which is converted by loop filter 40 into an analog signal (not shown) for controlling the phase of the clock signal S 12 of voltage-controlled oscillator 50.

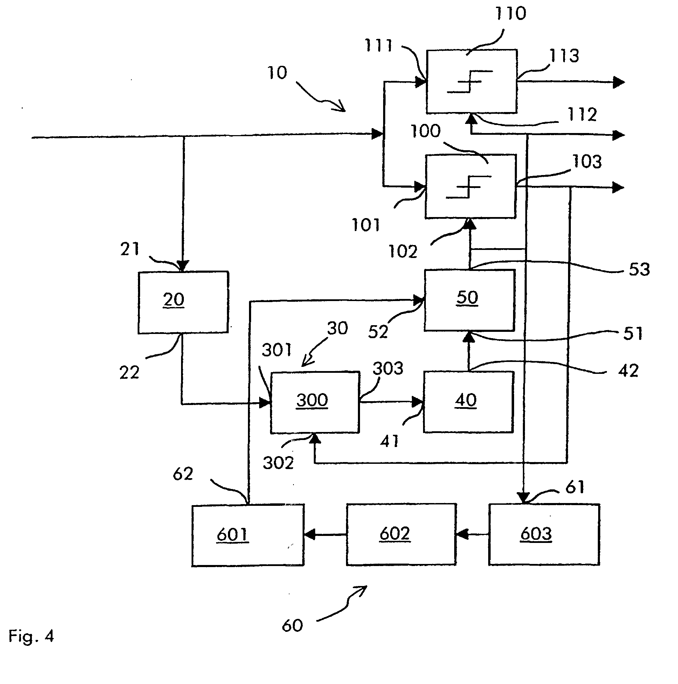

Fig. 4 is a schematic block diagram of a second embodiment of the invention in which like elements are designated by like reference characters. The second embodiment differs from the first embodiment mainly in that decision circuit 10 is implemented in the form of a demultiplexer decision circuit which, in the embodiment shown, comprises two interacting decision elements 100, 110. The data rate and the frequency of the clock signal to be recovered have a ratio of 1:0.5, i.e., the clock frequency is equal to half the bit rate.

Decision circuit 10 and phase detector 30 are implemented with D-flip flops 100, 110, and 300 having data inputs 101, 111, 301, clock inputs 102, 112, 302, and outputs 103, 113, 303. The demultiplexer function of the decision circuit is achieved by connecting the flip-flops 100, 110 in parallel, with the data signal being applied to the data inputs 101, 111, and the clock input 102 of one of the flip-flops, the flip-flop 100, and the inverted clock input 112 of the other flip-flop 110 being connected to the output 53 of voltage-controlled oscillator 50. This ensures that each flip-flop 100, 110 samples only given different parts of the data signal, i.e., that each flip-flop 100, 110 samples only every other data bit. Such a circuit arrangement is particularly suited for clock recovery from a 40-Gb/s signal. In D flip-flops, the limit for the frequency of signals to be processed is determined essentially by the clock frequency at which the flip-flop can be operated. The circuit arrangement shown requires D flip-flops that can be operated at a clock frequency equal to only half the signal frequency, i.e., at 20 GHz, for example. It is particularly advantageous that the outputs 103, 113 of D flip-flops 100, 110, which consequently have a signal frequency reduced by a factor of 2, are connected to the clock input 302 of the D flip-flop 300 of phase detector 30.

It is the combination of the interconnection of D flip-flops 100, 110, and 300 into demultiplexer decision circuit 10 and phase detector 30 and the feedback of the synchronized data signal to clock input 302 of phase detector 30 which permits clock recovery from data signals with up to twice the clock frequency of the D flip-flops used. Through the use of like components in decision circuit 10 and phase detector 30, effects due to thermal drift are reduced or partially compensated for. To those skilled in the art it is obvious that by connecting further flip-flops in parallel which are operated at a correspondingly reduced clock frequency, circuits with pulse duty factors other than the illustrated pulse duty factor of 1:0.5 can be constructed. The clock frequencies necessary for this can be generated by means of frequency dividers and/or frequency counters, for example.

As shown in Fig. 4, the frequency-locked loop 60 of the second embodiment comprises a frequency divider 603, a frequency counter 602, and a microprocessor 601 with suitable peripherals (not shown), such as memory, interfaces, input means, etc. A frequency-locked loop 60 of such a design permits easy handling or setting of the control frequency to different frequencies, e.g., for adaptation to different error-correcting techniques. Advantageously, the desired or control frequencies can be preset in a simple manner by software.

In addition, the delay circuit 20 can be preceded by a prefilter (not shown). This prefilter advantageously is implemented in the form of a directional coupler.

In a second embodiment of the circuit according to the invention, the clock signal of the data signal is determined by comparing the data signal with a demultiplexed, synchronized data signal. It is not readily apparent that the clock signal of an, e.g., 40-Gb/s data signal can be determined with the aid of a demultiplexed, synchronized 20-Gb/s data signal.

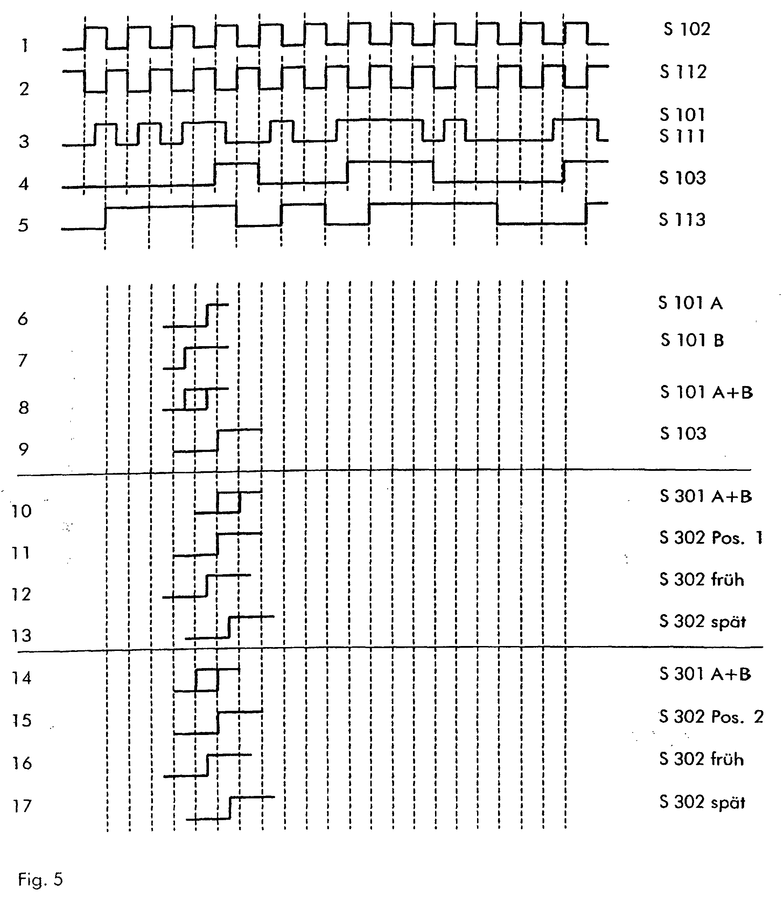

Fig. 5 is a timing diagram for the second embodiment of the invention, shown in Fig. 4.

Lines 1 and 2 show the clock signals S 102, S 112 of D flip-flops 100, 110, which are received from the output of the controlled oscillator 50 via the clock input 102 and the inverted clock input 112. Line 3 shows an exemplary bit sequence of a data signal S 101, S 111 as is presented to the data inputs 101, 111 of D flip-flops 100, 110. This data signal S 101 is sampled in the flip-flops 100 and 110 at one-half of the clock frequency of the data signal. The demultiplexed, synchronized data signals S 103 and S 113 are shown in lines 4 and 5. As a result of the demultiplexing, S 103 and S 113 are no longer identical in content to S 101, but they are correlated with the latter. This correlation permits a phase detection as is described in the following.

For the phase detection, at least one of the demultiplexed, synchronized data signals S 103, S 113 is compared with the suitably delayed data signal S 101. In the circuit shown in Fig. 4, the output 103 of flip-flop 100 is coupled to the input 302 of flip-flop 300, i.e., the synchronized, demultiplexed data signal S 103 is compared with the data signal S 101. For a better understanding, only short, exemplary bit sequences are represented.

As assumed above, the flip-flops in this embodiment are triggered on a rising edge, i.e., on a low-to-high transition at the clock input. In order that such a transition occurs at the clock input 302 of phase detector 300, a low/high bit sequence must occur at the output 103 of decision element 100, but a low/x/high bit sequence must occur at the input 101 of this decision element. The middle bit of the three bits, designated here by x, is sampled by decision element 110, but not by decision element 100.

In a real data signal, successive bits are independent of each other, and for each bit, high and low are equiprobable states. Therefore, on a time average, the bit x is equal to the average value of the low and high levels. Such time averaging of the signals from phase detector 300 is performed by loop filter 40. Lines 6 and 7 show two
possible patterns S 101A and S 101 B, and line 8 shows the superposition of the two possibilities as an eye diagram
S 101 A + B. This pattern S 101 A + B is fed to the data input 301 of phase detector 300 with a suitable delay introduced by delay circuit 20.

Line 9 shows the corresponding signal S 103 at the output of decision element 100 with the loop being in an optimum steady state condition. Decision element 100 has sampled only the first and the third bit and has masked off the middle bit. This signal is applied to the clock input 302 of the phase detector 300.

In phase detector 300, and the low/x/high bit sequence from delay circuit 20 is now sampled with the low/high bit sequence from decision element 100. With very early sampling, a permanent low level will appear at the output 303 of phase detector 300; with very late sampling, a permanent high level will appear. If the low/x/high bit sequence is sampled in the middle part, the state of bit x will be sampled, i.e., on a time average, the average value of low and high will appear at output 303. Experiments have shown that as a result of the statistical averaging of a plurality of phase evaluations, this uncertainty of the state of x is insignificant and does not appreciably affect the clock recovery from the data signal.

For the optimum setting of the delay, which must be performed only once at the beginning, there are two equivalent positions to choose between:

The first position, S 302 Pos. 1, shown in line 11 in relation to the signal S 301 A+B of line 10, brings the rising edge at the clock input 302 of phase detector 300 and the low-to-x transition at the input 301 to coincidence when the PLL is in the steady state condition, i.e., at the desired operating point. In that case, the low level is sampled at the phase detector output 303 when the clock signal S 53 or S 102/S 112 from oscillator 50 leads the data signal (line 12, S 302 early); when the clock signal logs the data signal, the average value is sampled (line 13, S 302 late).

The second position, S 302 Pos. 2, shown in line 15 in relation to the signal S 301 A+B of line 14, brings the rising edge at the clock input 302 of phase detector 300 and the x-to-high transition at the input 301 to coincidence when the PLL is in the steady state condition, i.e., at the desired operating point. In that case, the average value is sampled at the phase detector output 303 when the clock signal S 53 or S 102/S 112 from oscillator 50 leads the data signal (line 16, S 302 early); when the clock signal lags the data signal, the high level is sampled (line 17, S 302 late).

Instead of the output signal S 103 from decision element 100, S 113 from decision element 110 can be used for the phase comparison and be applied to the clock input 302 of phase detector 300. For the sake of clarity, this is not shown here.

In any case, the output signal of phase detector 300 is a criterion of the lead or lag of the clock signal recovered from the data. During operation of the circuit, a sequence of high, "average-value", and low bits will be applied which is converted via loop filter 40 into an analog signal (not shown) for controlling the clock signal of voltage-controlled oscillator 50 and adjusts the phase of the clock signal S 102/112 to an optimum value.

## Claims

1. A method of recovering a clock signal from a high bit rate data signal
wherein at least a first portion of the data signal is fed to a decision circuit and synchronized by means of the decision circuit (10, 100,110) with a clock signal from a controlled oscillator (50) wherein the phase difference between the synchronized signal and at least a second portion of the data signal, which is not fed to the decision circuit (10, 100, 110), is determined by means of a phase detector (30, 300), and
wherein the phase difference determined is processed by means of a loop filter (40) and used to control the clock signal of the controlled oscillator (50), with the portion of the data signal not fed to the decision circuit (10,100,110) and/or the synchronized portion of the data signal being delayed by means of a delay circuit (20) such that the portion of the data signal not fed to the decision circuit (10,100, 110) and the synchronized portion of the data signal are applied to the phase detector (30, 300) bit-synchronously, **characterized in that** the lock-in frequency of the controlled oscillator (50) is adjusted by means of a frequency-locked loop (60).

2. A method as set forth in daim 1, wherein the portion of the signal fed to the decision circuit (10) is demultiplexed.

3. An arrangement for recovering a clock signal from a high bit rate data signal, comprising: a decision circuit (10, 100,110) having a first input for the data signal, a second input for a clock signal, and an output; a delay circuit (20) having an input for the data signal and an output; a phase detector (30,300) ; a loop filter (40) ; and a controlled oscillator (50), the second input of the decision circuit (10, 100,110) being connected to a clock output of the controlled oscillator, the output of the decision circuit (10, 100,110) being connected to a first input of the phase detector, a second input of the phase detector (30, 300) being connected to the output of the delay circuit (20), and an output of the phase detector (30, 300) being connected via the loop filter(40) to an input of the controlled oscillator (50) **characterized by** a frequency-locked loop (60) for controlling the lock-in frequency of the controlled oscillator.

4. An arrangement as claimed in claim 3, wherein the decision circuit (10) is implemented as a demultiplexer decision circuit (100, 110).

5. An arrangement as set forth in claim 4, wherein the frequency-locked loop (60) comprises a frequency divider, a frequency counter, and a microprocessor.

6. An arrangement as set forth in claim 3, wherein the decision circuit (10) comprises a D flip-flop.

7. An arrangement as set forth in claim 6, wherein the decision circuit (10) comprises a comparator.

8. An arrangement as set forth in claim 3, wherein the phase detector (30) comprises a D flip-flop.

## Patentansprüche

1. Verfahren zur Rückgewinnung eines Taktsignals aus einem Datensignal hoher Bitrate, wobei zumindest ein erster Teil des Datensignals einer Entscheidungsschaltung zugeführt und mittels der Entscheidungsschaltung (10, 100, 110) mit einem Taktsignal von einem gesteuerten Oszillator (50) synchronisiert wird, wobei die Phasendifferenz zwischen dem synchronisierten Signal und zumindest einem zweiten Teil des Datensignals, der nicht der Entscheidungsschaltung (10, 100, 110) zugeführt wird, mittels eines Phasendetektors (30, 300) ermittelt wird, und wobei die ermittelte Phasendifferenz mittels eines Schleifenfilters (40) verarbeitet und zum Steuern des gesteuerten Oszillators (50) verwendet wird, wobei der Teil des Datensignals, der nicht der Entscheidungsschaltung (10, 100, 110) zugeführt wird, und/oder der synchronisierte Teil des Datensignals mittels einer Verzögerungsschaltung (20) so verzögert wird, daß der Teil des Datensignals, der nicht der Entscheidungsschaltung (10, 100, 110) zugeführt wird, und der synchronisierte Teil des Datensignals dem Phasendetektor (30, 300) bitsynchron zugeführt werden, **dadurch gekennzeichnet, daß** die Lock-in-Frequenz des gesteuerten Oszillators (50) mittels einer Frequenzregelschleife (60) eingestellt wird.

2. Verfahren gemäß Anspruch 1, wobei der Teil des Datensignals, welcher der Entscheidungsschaltung (10) zugeführt wird, demultiplext wird.

3. Vorrichtung zur Rückgewinnung eines Taktsignals aus einem Datensignal hoher Bitrate, beinhaltend eine Entscheidungsschaltung (10, 100, 110) mit einem ersten Eingang für das Datensignal, einem zweiten Eingang für ein Taktsignal und einem Ausgang; ferner eine Verzögerungsschaltung (20) mit einem Eingang für das Datensignal und einem Ausgang; des weiteren einen Phasendetektor (30, 300); ein Schleifenfilter (40) und einen gesteuerten Oszillator (50), wobei der zweite Eingang der Entscheidungsschaltung (10, 100, 110) mit einem Taktausgang des gesteuerten Oszillators verbunden ist, wobei der Ausgang der Entscheidungsschaltung (10, 100, 110) mit einem ersten Eingang des Phasendetektors verbunden ist, wobei ein zweiter Eingang des Phasendetektors (30, 300) mit dem Ausgang der Verzögerungsschaltung (20) verbunden ist, und wobei ein Ausgang des Phasendetektors (30, 300) über das Schleifenfilter (40) mit einem Eingang des gesteuerten Oszillators (50) verbunden ist, **gekennzeichnet durch** eine Frequenzregelschleife (60) zum Regeln der Lock-in-Frequenz des gesteuerten Oszillators.

4. Vorrichtung gemäß Anspruch 3, in welcher die Entscheidungsschaltung (10) als Demultiplexer-Entscheidungsschaltung (100, 110) implementiert ist.

5. Vorrichtung gemäß Anspruch 4, in welcher die Frequenzregelschleife (60) einen Frequenzteiler, einen Frequenzzähler und einen Mikroprozessor beinhaltet.

6. Vorrichtung gemäß Anspruch 3, in welcher die Entscheidungsschaltung (10) ein D-Flipflop beinhaltet.

7. Vorrichtung gemäß Anspruch 6, in welcher die Entscheidungsschaltung (10) einen Komparator beinhaltet.

8. Vorrichtung gemäß Anspruch 3, in welcher der Phasendetektor (30) ein D-Flipflop beinhaltet.

## Revendications

1. Méthode pour récupérer un signal d'horloge d'un signal de données à haut débit dans laquelle au moins une première partie du signal de données est fournie à un circuit de décision et synchronisée au moyen d'un circuit de décision (10, 100, 110) avec un signal d'horloge d'un oscillateur contrôlé (50) dans laquelle la différence de phase entre le signal synchronisé et au moins une deuxième partie du signal de données qui n'est pas fournie au circuit de décision (10, 100, 110) est déterminée au moyen d'un détecteur de phase (30, 300) et dans laquelle la différence de phase déterminée est traitée au moyen d'un filtre de boucle (40) et utilisée pour contrôler le signal d'horloge de l'oscillateur contrôlé (50), la partie non fournie au circuit de décision (10, 100, 110) et/ou la partie synchronisée du signal de données étant retardées au moyen d'un circuit de retard (20) de manière telle que le signal de données non fourni au circuit de décision (10, 100, 110) et la partie synchronisée du signal de données sont appliquées au détecteur de phase (30, 300) en synchronisation de bit, **caractérisée en ce que** la fréquence de verrouillage de l'oscillateur contrôlé 50 est ajustée au moyen d'une boucle à verrouillage de fréquence 60.

2. Méthode selon la revendication 1, dans laquelle une partie du signal fourni au circuit de décision (10) est démultiplexée.

3. Disposition pour récupérer un signal d'horloge d'un signal de données haut débit, comprenant : un circuit de décision (10, 100, 110) ayant une première entrée pour le signal de données, une deuxième entrée pour un signal d'horloge et une sortie ; un circuit de retard (20) ayant une entrée pour le signal de données et une sortie ; un détecteur de phase (30, 300) ; un filtre de boucle (40) ; et un oscillateur contrôlé (50), la deuxième entrée du circuit de décision (10, 100, 110) étant connectée à une sortie d'horloge de l'oscillateur contrôlé, la sortie du circuit de décision (10, 100, 110) étant connectée à une première entrée du détecteur de phase, une deuxième entrée du détecteur de phase (30, 300) étant connectée à la sortie du circuit de retard (20) et une sortie du détecteur de phase (30, 300) étant connectée par le filtre de boucle (40) à une entrée de l'oscillateur contrôlé (50), **caractérisée par** une boucle à verrouillage de fréquence (60) pour contrôler la fréquence de verrouillage de l'oscillateur contrôlé.

4. Disposition selon la revendication 3, dans laquelle le circuit de décision (10) est implémenté en tant que circuit de décision démultiplexeur (100, 110).

5. Disposition selon la revendication 4, dans laquelle la boucle à verrouillage de fréquence (60) comprend un diviseur de fréquence, un compteur de fréquence et un microprocesseur.

6. Disposition selon la revendication 3, dans laquelle le circuit de décision (10) comprend une bascule D.

7. Disposition selon la revendication 6, dans laquelle le circuit de décision (10) comprend un comparateur.

8. Disposition selon la revendication 3, dans laquelle le détecteur de phase (30) comprend une bascule D.
